(19) **Europäisches Patentamt**
**European Patent Office**
**Office européen des brevets**

(11) Veröffentlichungsnummer: **0 259 613 B1**

(12) # EUROPÄISCHE PATENTSCHRIFT

(45) Veröffentlichungstag der Patentschrift: **07.08.91**

(51) Int. Cl.⁵: **H01G 1/147**

(21) Anmeldenummer: **87111356.9**

(22) Anmeldetag: **05.08.87**

(54) **Verfahren zur Herstellung von Füllschichtbauteilen.**

(30) Priorität: **18.08.86 DE 3627936**

(43) Veröffentlichungstag der Anmeldung:
**16.03.88 Patentblatt 88/11**

(45) Bekanntmachung des Hinweises auf die
Patenterteilung:
**07.08.91 Patentblatt 91/32**

(84) Benannte Vertragsstaaten:
**AT BE CH DE ES FR GB IT LI**

(56) Entgegenhaltungen:
**US-A- 3 679 950**
**US-A- 4 071 880**

(73) Patentinhaber: **Siemens Aktiengesellschaft**
**Wittelsbacherplatz 2**
**W-8000 München 2(DE)**

(72) Erfinder: **Moser, Thomas, Dipl.-Ing.**
**Schlesienstrasse 35**
**W-8563 Schnaittach(DE)**
Erfinder: **Otto, Klaus, Dipl.-Chem.**
**Klingenfeldstrasse 54**
**W-8500 Nürnberg(DE)**
Erfinder: **Kippenberg, Horst, Dr.**
**Sudetenring 24**
**W-8522 Herzogenaurach(DE)**
Erfinder: **Krause, Ralf-Dieter, Dipl.-Ing.**
**Reichenschwander Strasse 18**
**W-8500 Nürnberg 30(DE)**

## Beschreibung

Die Erfindung bezieht sich auf ein Verfahren zur Herstellung von Füllschichtbauteilen aus monolithischer Keramik.

Gesinterte keramische Körper mit porösen und dichten Schichten können z.B. nach der DE-PS 24 62 006, der DE-PS 24 62 008 oder der DE-PS 24 45 087 hergestellt werden. Solche teilweise porösen Keramikteile werden dann beispielsweise nach der DE-PS 22 18 170 oder DE-PS 22 64 943 mit elektrisch leitenden Metallfüllungen versehen, wobei sich unterschiedliche Verfahrenstechnologien anbieten. Bekannt ist unter anderem das Tränken mit Silbernitratlösung mit anschließender Zersetzung des Silbernitrats bei höherer Temperatur unter Bildung eines Niederschlages oder auch ein Tränken mit Silbernitratlösung mit anschließender Reduktion des Silbernitrates mit Wasserstoff bei höherer Temperatur zum metallischen Silber. Bewährt hat sich aber auch insbesondere das Drucktränken mit flüssigen Metallen oder Legierungen, beispielsweise Wismut (Bi)-, Blei (Pb)-, Aluminium (Al)-, Kupfer (Cu)-, Zink (Zn)-, Zinn (Sn)- oder auch Cadmium (Cd)-Legierungen.

Für den bestimmungsgemäßen Gebrauch der Bauteile müssen Kontaktierungen auf die Keramik aufgebracht sein, die eine elektrische Anbindung zu der Metallfüllung gewährleisten und damit eine Weiterverarbeitung zu beispielsweise Kondensatoren in SMD-Bauweise ermöglichen. Für das Aufbringen der Kontaktierungen kommen z.B. das Einbrennen von Edelmetallpasten oder aber auch Metallbeschichtungsverfahren über die Gasphase in Frage.

Es ist bereits bekannt, Füllschichtbauteile durch das erwähnte Drucktränken oder auch durch sogenanntes Schleudertränken mit flüssigen Metallen oder Legierungen herzustellen. Dabei müssen die Kontaktierungen speziell als poröse Metallschichten auf die Keramikrohlinge aufgebracht werden. Nur auf diese Weise war es bisher möglich, eine elektrische Anbindung zwischen der Metallfüllung und den Kontaktierungen herzustellen, da nach dem Druck- oder Schleudertränken ohne Kontaktierungen bzw. andere Sperrschichten die herkömmlichen Tränkwerkstoffe beim Herausnehmen der Bauteile aus dem flüssigen Tränkbad zumindest teilweise wieder aus der Keramik auslaufen. Werden aber vor dem Tränkvorgang poröse Kontaktierungen aus Edelmetall aufgebracht, können Probleme dadurch auftreten, daß sich die Edelmetallschichten während des Drucktränkens unzulässig stark in herkömmlichen Metallbädern ablösen.

Speziell in der DE-AS 23 23 921 wird deswegen das Aufbringen einer porösen, gesinterten Glas-Grenzschicht auf die Endflächen der Keramikkörper beschrieben, die ein Auslaufen des flüssigen Werkstoffes nach dem eigentlichen Tränkvorgang behindern soll. Diese Glas-Grenzschicht muß nach dem Tränken in einem separaten Verfahrensschritt wieder entfernt werden, worauf anschließend die Kontaktierungen aufgebracht werden.

Daneben wird in der neueren DE-OS 35 09 593 vorgeschlagen, auf den Keramikkörper dünne haftende, vom Metallbad benetzbare Schichten aufzubringen, um das Auslaufen des flüssigen Tränkwerkstoffes beim Herausziehen der Teile aus dem Bad zu verhindern. Auch solche Schichten müssen bei Fertigstellung des Füllschichtbauteils zu einem Kondensator verstärkt bzw. in einem lötfähigen Zustand versetzt werden. Dies bedeutet eine Wiederholung von Arbeitsschritten nach Unterbrechung durch den Tränkvorgang, was eine wirtschaftliche Fertigung verhindert.

Diese bekannte Herstellungstechnologie ist insgesamt aufwendig und unsicher.

Aufgabe der Erfindung ist es demgegenüber, die Herstellung von Füllschichtbauteilen, insbesondere von Keramikkondensatoren, durch Drucktränken von porösen Keramikteilen zu vereinfachen.

Die Aufgabe ist erfindungsgemäß durch die Merkmale des Anspruchs 1 gelöst.

Beim Drucktränken von porösen Keramikrohteilen ohne Kontaktierungen muß das Auslaufen des Tränkwerkstoffes beim Herausnehmen der Teile aus dem schmelzflüssigen Tränkbad nach dem Drucktränkprozeß verhindert werden. Dies wird bei vorliegender Erfindung vorteilhafterweise durch den Einsatz von die Keramik benetzenden Tränkwerkstoffen erreicht. Letzteres kann insbesondere durch Indium erfolgen, dessen benetzenden Eigenschaften gegenüber Glas bekannt sind (Materials and Methods, Vol. 36 (1952), S. 113 bis 115).

Insbesondere haben sich Pb-In-Legierungen als Tränkwerkstoffe bewährt, aber auch Cu-In- oder Ag-In- Legierungen und weitere Werkstoffe sind denkbar. Verwendet man speziell die Legierungen PbAg5In5, PbIn2,5 oder auch PbIn5 als Tränkwerkstoff, so erfolgt aufgrund der benetzenden Wirkung des Indiums kein Auslaufen der Metallfüllung beim Herausnehmen der Keramikteile aus dem Tränkbad und die Teile bleiben vollständig gefüllt. Nach dem Tränkvorgang kann dann in beliebiger Weise das Aufbringen der Kontaktierungen und die elektrische Anbindung zwischen Metallfüllung und Kontaktierungen erfolgen. Beispielsweise können gebräuchliche Edelmetallpasten mit geeigneter Einbrenntemperatur auf die zu kontaktierenden Keramikflächen aufgebrannt werden, wobei gleichzeitig der Anbindevorgang erfolgt. Dabei ist es notwendig, daß die Wärmebehandlung unterhalb des Schmelzpunktes der Kontaktierungen, aber vorteilhaft oberhalb der Schmelztemperatur des Tränkwerkstoffes erfolgt. Letzterer tritt nämlich aufgrund der temperaturbedingten Volumenausdehnung und aufgrund des Phasenüberganges fest-flüssig aus den zu kontaktierenden Poren der Keramik aus, was das Anbinden der Kontaktierungen zu der Metallfüllung ermöglicht.

Die Kontaktierungen können auch durch bekannte Oberflächenbeschichtungsverfahren, beispielsweise Aufdampfen oder Sputtern, aufgebracht werden. Falls erforderlich, können diese galvanisch verstärkt und gegebenenfalls durch eine Wärmebehandlung oberhalb der Schmelztemperatur des Tränkwerkstoffes angebunden werden. Als obere Einsatztemperatur von derart hergestellten Kondensatoren ist die Schmelztemperatur des Tränkwerkstoffes anzusehen, da sich bei wiederholtem Aufschmelzen der Metallfüllung Veränderungen der elektrischen Kenndaten ergeben können. Vorzugsweise sollen dabei die Schmelzpunkte der Tränkwerkstoffe oberhalb der Schmelztemperatur herkömmlicher Lotbäder liegen, welche beim bestimmungsgemäßen Gebrauch der Bauteile verwendet werden.

Weitere Einzelheiten und Vorteile der Erfindung ergeben sich aus der nachfolgenden Figurenbeschreibung anhand der Zeichnung und den zugehörigen Beispielen. Es zeigen

FIG 1 ein Füllschichtbauteil, das mit einem nichtbenetzenden Werkstoff getränkt ist,

FIG 2 und FIG 3 ein Füllschichtbauteil gemäß der Erfindung sowie

FIG 4 einen Teilausschnitt aus FIG 3.

In den Figuren sind identische Teile mit gleichen Bezugszeichen versehen. Die Figuren werden teilweise zusammen beschrieben.

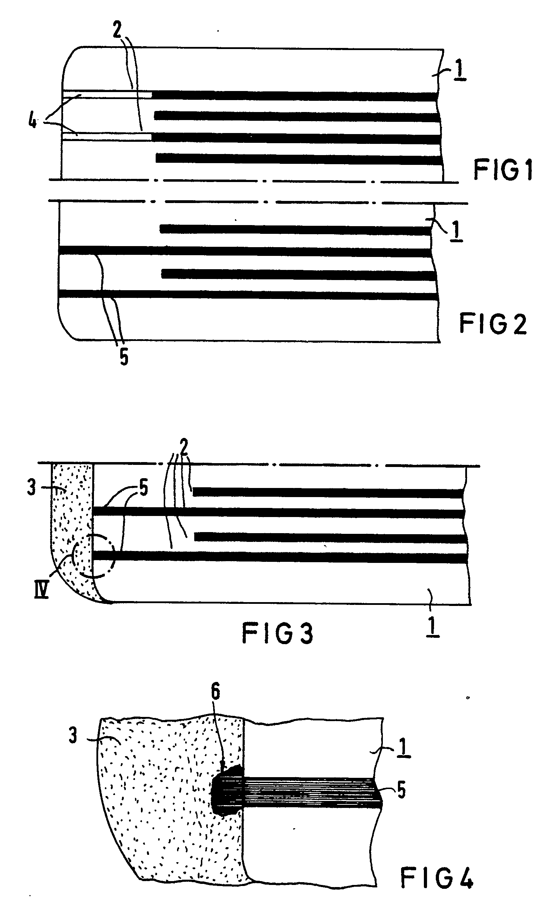

In FIG 1 und FIG 2 ist ein Ausschnitt aus einem Bauteil 1 dargestellt, das einen Schichtaufbau aus dichten und porösen Schichten 2 aufweist.

Werden die porösen Schichten mit metallischen Werkstoffen gefüllt und die Seitenflächen des Bauteiles entsprechend FIG 3 mit metallischen Schichten als Kontaktierungen 3 versehen, so lassen sich aufgrund der dielektrischen Eigenschaften der Keramik Kondensatoren realisieren. Dazu müssen die porösen Schichten 2 in geeigneter Weise mit einem Tränkmetall gefüllt werden. Letzteres erfolgt beispielweise durch Druck- oder Schleudertränken, wofür beispielsweise Blei-Basis-Werkstoffe verwendet werden.

In FIG 1 ist ein mit Blei getränktes Bauteil 1 gezeigt. Aufgrund der Nichtbenetzbarkeit der Keramik durch Blei läuft nach dem Drucktränken beim Herausnehmen des Bauteils 1 aus dem flüssigen Tränkbad das Blei zumindest teilweise wieder aus der Keramik aus. Es ergeben sich so in den Schichten 2 zu den Randbereichen hin nur unvollständig ausgefüllte Schichtbereiche 4. Dadurch wird die anschließende elektrische Anbindung an die Kontaktierungen verhindert.

Um ein Auslaufen des flüssigen Tränkwerkstoffes zu verhindern, wurden bisher in der Praxis die Außenflächen des keramischen Bauteiles 1 mit feinporösen Überzügen, z.B. durch Aufsintern von Glasfritten, die nach dem Drucktränken mechanisch entfernt werden mußten, beschichtet. Bekannt ist auch das Aufbrennen von Silberpasten als Kontaktierungen als Vorabschritt, durch die ein Drucktränken möglich ist. In jedem Fall war aber ein zusätzlicher Aufwand notwendig.

In FIG 2 ist das gleiche keramische Bauteil 1 wie FIG 1 mit einer die Keramik im flüssigen Zustand benetzenden Legierung gezeigt. Man erkennt, daß die Bereiche 2 voll mit Tränkwerkstoff ausgefüllt sind, so daß in diesem Fall Kontaktierungen 3 anschließend aufgebracht und elektrisch an die Metallfüllung angebunden werden können.

Die elektrische Anbindung von Metallfüllung 5 und Kontaktierungen 3 wird aus FIG 3 und 4 deutlich. Es zeigt sich, daß bei Wärmebehandlungen aufgrund der temperaturbedingten Volumenausdehnung und aufgrund des Phasenüberganges festflüssig Tränkwerkstoff der Metallfüllung 5 aus den zu kontaktierenden Bereichen 2 der Keramik austritt. Vorteilhafterweise erfolgt die Wärmebehandlung unterhalb des Schmelzpunktes der Kontaktierungen, aber oberhalb der Schmelztemperatur des Tränkwerkstoffes. Das Anbinden der Kontaktierungen zu der Metallfüllung ist in den Bereichen 6 erreicht.

Die Verfahrensführung zur Herstellung von Keramikbauteilen mit geeigneten elektrischen Eigenschaften ergibt sich aus den nachfolgenden Beispielen:

Beispiel 1:

Es sollen Hohlraumkeramikteile mit PbIn5 druckgetränkt werden. Es wird eine Verfahrenstemperatur von 420 °C gewählt und 30 Sek. bei 10 bar im Autoklaven getränkt. Die Kontaktierungen werden anschließend durch Tauchen in Edelmetallpaste und darauffolgendem Einbrennen aufgebracht. Die elektrische Anbindung erfolgt gleichzeitig mit dieser Wärmebehandlung, die beispielsweise 60 Min. bei 550 °C in Luftatmosphäre sein kann. Als Auf- und Abheizgeschwindigkeit bei der Wärmebehandlung wurde 15 K/min. gewählt.

Beispiel 2:

Es werden Hohlraumkeramikteile, entsprechend Beispiel 1 mit PbIn5 bei 420 °C 30 sek. und 10 bar im Autoklaven getränkt. Anschließend werden die Außenseiten mit NiAg gesputtert und galvanisch verstärkt. Es erfolgt eine separate Temperaturbehandlung zum Anbinden der Kontaktierungen an die Metallfüllung, beispielsweise 10 Min. bei 400 °C in Luftatmosphäre, wobei die Auf-und Abheizgeschwindigkeit wieder 15 K/Min. gewählt wurde.

Beispiel 3:

Es wird PbAg5In5 als Tränkwerkstoff gewählt, wobei die Verfahrenstemperatur zwischen 350 und 500 °C und der Druck zwischen 5 und 10 bar gewählt wird. Die Kontaktierungen können nach Beispiel 1 oder Beispiel 2 hergestellt werden.

Beispiel 4:

Hohlraumkeramikteile werden entsprechend Beispiel 1 oder Beispiel 3 getränkt. Dann werden die Außenseiten mit NiCr/Ag und anschließend mit der gewünschten Schichtfolge, z.B. NiCr/Ag/Ni/Sn durch Sputtern oder galvanisches Abscheiden fertiggestellt. Eine separate Temperaturbehandlung nach dem Sputterprozeß gemäß Beispiel 2 hat keine nachteiligen Auswirkungen auf die geforderten elektrischen Eigenschaften.

Die gemäß den einzelnen Ausführungsbeispielen aufgebrachten Schichten haben sich als gut lötbar erwiesen, wobei die Haftfähigkeit ausreichend ist. Bei allen aus derartigen Füllschichtbauteilen hergestellten Kondensatoren entsprechen die elektrischen Kapazitäten den geforderten Werten.

## Patentansprüche

1. Verfahren zur Herstellung von Füllschichtbauteilen aus monolithischer Keramik mit folgenden Schritten:
   a) Tränken eines keramischen Schichtaufbaus aus dichten und porösen Schichten mit einem flüssigen, metallischen Tränkwerkstoff aus einem Metall oder einer Legierung, die im flüssigen Zustand die Keramik benetzt, zur Erzeugung einer Metallfüllung in den porüsen Schichten und
   b) Aufbringen von Kontaktierungen im Anschluß an den Tränkprozeß ohne weitere Zwischenschritte, wobei eine elektrische Anbindung der Kontaktierungen (3) an die Metallfüllung (5, 6) erfolgt.

2. Verfahren nach Anspruch 1, **dadurch gekennzeichnet,** daß eine Legierung als Tränkwerkstoff derart gewählt ist, daß deren Schmelzpunkt niedriger ist als der Schmelzpunkt der Kontaktierungen (3), vorzugsweise unterhalb von 850 °C, und höher ist als die beim bestimmungsgemäßen Gebrauch der Bauteile verwendeten Löttemperaturenen, vorzugsweise oberhalb von 180 °C.

3. Verfahren nach Anspruch 1, **dadurch gekennzeichnet,** daß der Tränkwerkstoff eine Blei-Indium-Legierung mit mehr als 0,5 m-% Indium ist.

4. Verfahren nach Anspruch 3, **dadurch gekennzeichnet,** daß die Blei-Indium-Legierung einen Indiumanteil ≥ 2 m-%, vorzugsweise zwischen 2,5 und 20 m-%, hat.

5. Verfahren nach Anspruch 1, **dadurch gekennzeichnet,** daß das Aufbringen der Kontaktierungen nach dem Tränkprozeß durch Metallisierungstechniken, beispielsweise durch Aufbringen von Metallpasten, Sputtern von metallischen Werkstoffen oder dgl., erfolgt.

6. Verfahren nach einem der vorhergehenden Ansprüche, **dadurch gekennzeichnet,** daß die Anbindung der durch das Tränken erzeugten Metallfüllung an die anschließend auf den Keramikkörper aufgebrachten Kontaktierungen durch eine Wärmebehandlung erfolgt.

7. Verfahren nach Anspruch 6, **dadurch gekennzeichnet,** daß die Wärmebehandlung gleichzeitig mit dem Aufbringen der Kontaktierungen durchgeführt wird.

8. Verfahren nach Anspruch 6, **dadurch gekennzeichnet,** daß die Wärmebehandlung in einem separaten Verfahrensschritt im Anschluß an das Aufbringen der Kontaktierungen erfolgt.

9. Verfahren nach einem der Ansprüche 6 bis 8, **dadurch gekennzeichnet,** daß die Temperatur zum Anbinden der Metallfüllung an die Kontaktierungen oberhalb des Schmelzpunktes des Tränkwerkstoffes liegt.

## Claims

1. Method for the production of filled layer components of monolithic ceramics, with the following steps:
   a) impregnation of a ceramic layer structure consisting of dense and porous layers with a fluid, metallic impregnating material consisting of a metal or an alloy, which in the fluid state wets the ceramics, for the purpose of producing a metal filling in the porous layers;
   b) application of contacts following the impregnation process without further intermediate steps, with an electrical bonding of the contacts (3) to the metal filling (5, 6) occurring thereby.

2. Method according to claim 1, characterised in that an alloy is chosen as impregnating material such that the melting point thereof is lower than the melting point of the contacts (3), preferably below 850°C, and is higher than the soldering temperatures applied in the use of the components, as directed, preferably above 180°C.

3. Method according to claim 1, characterised in that the impregnating material is a lead-indium alloy with more than 0.5 m-% indium.

4. Method according to claim 3, characterised in that the lead-indium alloy has an indium content ≥ 2 m-%, preferably between 2.5 and 20 m-%.

5. Method according to claim 1, characterised in that the application of the contacts after the impregnation process occurs by metallization techniques, for example, by application of metal pastes, sputtering of metallic materials or the like.

6. Method according to one of the preceding claims, characterised in that the bonding of the metal filling, produced by the impregnation, to the contacts subsequently applied to the ceramic body occurs by means of heat treatment.

7. Method according to claim 6, characterised in that the heat treatment is carried out at the same time as the application of the contacts.

8. Method according to claim 6, characterised in that the heat treatment occurs in a separate method step following the application of the contacts.

9. Method according to one of the claims 6 to 8, characterised in that the temperature for bonding the metal filing to the contacts lies above the melting point of the impregnating material.

## Revendications

1. Procédé de fabrication de composants à couches garnies en céramique monolithique comprenant les étapes suivantes :

   a) imprégnation d'une structure céramique en couches constituée de couches étanches et de couches poreuses à l'aide d'un matériau d'imprégnation liquide et métallique constitué d'un métal ou d'un alliage qui, à l'état liquide, mouille la céramique pour produire un garnissage de métal dans les couches poreuses,

   b) dépôt de contacts à la suite du processus d'imprégnation sans autre stade intermédiaire avec obtention d'une liaison électrique des contacts (3) avec le garnissage de métal (5, 6).

2. Procédé selon la revendication 1, caractérisé en ce qu'il consiste à choisir, comme matériau d'imprégnation, un alliage, dont le point de fusion est inférieur au point de fusion des contacts (3), en étant de préférence inférieur à 850°C et est supérieur aux températures de soudage utilisées, en fonction de la destination, des composants suivant les normes prescrites, en étant supérieur de préférence à 180°C.

3. Procédé selon la revendication 1, caractérisé en ce que le matériau d'imprégnation et un alliage de plomb et d'indium ayant plus de 0,5 % en moles d'indium.

4. Procédé selon la revendication 3, caractérisé en ce que l'alliage de plomb et d'indium a une proportion d'indium 2 % en moles et de préférence comprise entre 2,5 à 20 % en moles.

5. Procédé selon la revendication 1, caractérisé en ce qu'il consiste à effectuer le dépôt des contacts après le processus d'imprégnation par des techniques de métallisation, par exemple par dépôt de pâtes métalliques par pulvérisation cathodique de matériaux métalliques ou analogues.

6. Procédé selon l'une des revendications précédentes, caractérisé en ce qu'il consiste à effectuer la liaison du garnissage de métal produit par l'imprégnation avec les contacts déposés ensuite sur le corps en céramique par un traitement thermique.

7. Procédé selon la revendication 6, caractérisé en ce qu'il consiste à effectuer le traitement thermique simultanément au dépôt des contacts.

8. Procédé selon la revendication 6, caractérisé en ce qu'il consiste à effectuer le traitement thermique dans un stade de procédé distinct, à la suite du dépôt des contacts.

9. Procédé selon l'une des revendications 6 à 8, caractérisé en ce que la température pour la liaison du garnissage métallique avec les contacts est supérieure au point de fusion du matériau d'imprégnation.

FIG 1

FIG 2

FIG 3

FIG 4